(19) **Europäisches Patentamt European Patent Office Office européen des brevets**

(11) **EP 4 624 637 A1**

(12) **EUROPEAN PATENT APPLICATION**
published in accordance with Art. 153(4) EPC

(43) Date of publication:
01.10.2025 Bulletin 2025/40

(21) Application number: 24766734.8

(22) Date of filing: 02.02.2024

(51) International Patent Classification (IPC):
$C25D\ 11/18$ (2006.01)  $B32B\ 7/023$ (2019.01)
$B32B\ 9/00$ (2006.01)  $B32B\ 9/04$ (2006.01)
$B32B\ 15/04$ (2006.01)  $B32B\ 15/20$ (2006.01)
$C23C\ 26/00$ (2006.01)  $C23C\ 28/02$ (2006.01)
$C25D\ 11/04$ (2006.01)  $G02B\ 5/08$ (2006.01)

(52) Cooperative Patent Classification (CPC):
B32B 7/023; B32B 9/00; B32B 9/04; B32B 15/04;
B32B 15/20; C23C 26/00; C23C 28/02;
C25D 11/04; C25D 11/18; G02B 5/08

(86) International application number:
PCT/JP2024/003541

(87) International publication number:
WO 2024/185359 (12.09.2024 Gazette 2024/37)

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: 06.03.2023 JP 2023033478

(71) Applicant: **UACJ Corporation
Chiyoda-ku
Tokyo 100-0004 (JP)**

(72) Inventor: **NAKAJIMA, Daiki
Tokyo 100-0004 (JP)**

(74) Representative: **Kramer Barske Schmidtchen
Patentanwälte PartG mbB
European Patent Attorneys
Landsberger Strasse 300
80687 München (DE)**

(54) **METAL MEMBER AND METHOD FOR MANUFACTURING SAME**

(57) A metal member (1) has: a substrate (2), which is composed of a metal; a transparent layer (3), which is composed of a material that transmits visible light, and is provided on the substrate (2); and a reflective layer (4), which is provided on the transparent layer (3). The mean value of the spectral transmittance of the reflective layer (4), in the wavelength range of 400 nm or longer and 700 nm or shorter, is 2% or more and 80% or less. In addition, the reflective layer (4) is constituted such that a portion of the visible light that is incident on the reflective layer (4) is reflectable. The metal member (1) is obtained, for example, by performing an anodizing treatment on the substrate (2) in a weakly acidic or weakly basic electrolytic solution so as to form the transparent layer (3), and then performing a sputtering treatment so as to form the reflective layer (4) on the transparent layer (3).

FIG. 1

EP 4 624 637 A1

**Description**

TECHNICAL FIELD

The present invention relates to a metal members and methods for manufacturing the same.

BACKGROUND ART

Metal members may be used in applications for which good aesthetics are required, for example, in building materials and electronic equipment cases. The surfaces of these types of metal members may be colored in order to enhance the aesthetics.

For example, Patent Document 1 describes a decorative work method for a metal surface characterized by performing a base surface treatment as a first step, and next depositing a layer of a transparent thin film of a silicon compound, two or more times, as a second step, so as to make a decorative pattern on the metal surface.

PRIOR ART LITERATURE

Patent Documents

Patent Document 1: JP 2014-4700 A

SUMMARY OF THE INVENTION

PROBLEMS TO BE SOLVED BY THE INVENTION

In recent years, there has been a demand for coloring metal members by simpler methods and in a more vivid manner than with the metal surface decoration method of Patent Document 1.

The present invention was made in view of this background, and is directed to providing a metal member, which can be obtained by a simple method, and which is capable of exhibiting vivid chromatic colors, and a method for manufacturing the same.

MEANS FOR SOLVING THE PROBLEMS

One aspect of the present invention is a metal member having:

a substrate, which is composed of a metal;
a transparent layer, which is composed of a material that transmits visible light, and is provided on the substrate; and
a reflective layer, which is provided on the transparent layer,
wherein the reflective layer is constituted such that the mean value of the spectral transmittance, in a wavelength range of 400 nm or longer and 700 nm or shorter is, 2% or more and 80% or less and a portion of the visible light that is incident on the reflective layer is reflectable.

Another aspect of the present invention is a method for manufacturing a metal member of the aforementioned aspect, wherein:

the transparent layer is formed by performing an anodizing treatment on the substrate in a weakly acidic or weakly basic electrolytic solution; and
thereafter the reflective layer is formed on the transparent layer by performing a sputtering treatment.

EFFECTS OF THE INVENTION

The metal member has a substrate, a transparent layer, which is provided on the substrate, and a reflective layer, which is provided on the transparent layer. In addition, because the reflective layer is constituted such that a portion of the visible light, which is incident on the reflective layer reflectable, light, which has reflected at the reflective layer, and light, which has passed through the reflective layer and the transparent layer and is reflected at the substrate, can be caused to interfere with each other.

In addition, the reflective layer has the aforementioned specific optical properties. By providing the specific reflective layer on the substrate, the metal member allows the ratio of the intensity of light reflected at the reflective layer and the intensity of light reflected at the substrate to be controlled in a suitable range. As a result of the foregoing, the surface of the metal member can be colored in vivid color tones by the optical interference.

In addition, in the manufacturing method, after performing anodizing treatment on the surface of the substrate so as to form a transparent layer, the sputtering treatment is performed so as to form a reflective layer on the transparent layer. The metal member can thereby easily be obtained.

As described above, according to the aforementioned aspects, it is possible to provide a metal member, which can be obtained by a simple method, and which can exhibit vivid chromatic colors, and to provide a method for manufacturing the same.

BRIEF DESCRIPTION OF THE DRAWINGS

FIG. 1 is a cross-sectional view schematically illustrating a metal member in Exemplary Embodiment 1.

FIG. 2 is a graph illustrating the spectral transmittance of glass substrates, which are provided with a reflective layer in Exemplary Embodiment 2.

FIG. 3 is a transmission electron microscope image of a reflective layer in Test Material A2 in Exemplary Embodiment 2.

FIG. 4 is a cross-sectional view schematically illustrating a metal member comprising a protective layer in Exemplary Embodiment 2.

MODES FOR CARRYING OUT THE INVENTION

Metal Member

The substrate of the metal member is composed of a metal. For example, a metal exhibiting an achromatic color such as white, gray, grayish-white, or silvery-white preferably can be used as the metal that constitutes the substrate. Metals exhibiting such color tones include, for example, iron, iron alloys, aluminum, aluminum alloys, titanium, titanium alloys, and the like. By using a metal having an achromatic color as the substrate of the metal member, the influence exerted by the color tone of the substrate on the color tone of the metal member can be reduced, and a metal member having the desired color tone can be obtained more easily.

Preferably, aluminum, aluminum alloys, titanium, or titanium alloys are used as the metal that constitutes the substrate. Due to their low chroma, these metals can further reduce the influence of the color tone of the substrate on the color tone of the metal member. Furthermore, it is possible to easily form a transparent layer, which is composed of an oxide, on the surface of the substrate by performing an anodizing treatment on a substrate that is composed of these metals. Among these metals, from the viewpoint of reducing material costs, the metal that constitutes the substrate is more preferably aluminum or an aluminum alloy.

The material of the aluminum or aluminum alloy that constitutes the substrate is not particularly limited, and can be selected as appropriate depending on the application of the metal member, the required mechanical properties, and the like. For example, if high strength is required of the metal member, it is preferable to use a substrate composed of a 5000 series alloy or a 6000 series alloy. In addition, when excellent aesthetics are required of the metal member, it is preferable to use a substrate composed of a 1000 series aluminum or a 6000 series alloy that is not readily discolored by the anodizing treatment.

A transparent layer, which is composed of a material that transmits visible light, is provided on the substrate. The material that constitutes the transparent layer may be an organic material or may be an inorganic material. The transparent layer is preferably composed of an inorganic material. Transparent layers composed of inorganic materials are less likely to deteriorate due to temperature changes, humidity changes, irradiation with sunlight, or the like, during use of the metal member, and the optical properties can be maintained over a longer period of time. Thus, by providing a transparent layer composed of an inorganic material on the substrate, the color tone of the metal member can be maintained over a longer period of time.

In addition, the transparent layer is preferably composed of an oxide of the metal that constitutes the substrate. Since metal oxides are less likely to deteriorate due to temperature changes, humidity changes, exposure to sunlight, and the like, by providing a transparent layer composed of an oxide on the substrate, the color tone of the metal member can be maintained over a longer period of time. Furthermore, in this case, since the transparent layer can be grown from the surface of the substrate by performing the anodizing treatment on the substrate, formation of gaps at the interface between the substrate and the transparent layer and contamination by foreign matter can be prevented. As a result, the occurrence of unevenness in color tone and defects in the metal member can be more effectively curtailed.

The thickness of the transparent layer is preferably 15 nm or more and 600 nm or less. In this case, light waves having wavelengths in the visible light region can be strengthened by the interference between the light reflected at the reflective layer and the light reflected at the substrate. As a result, the metal member can be colored in a variety of color tones.

A reflective layer, which is constituted such that the mean value of the spectral transmittance, in the wavelength range of 400 nm or longer and 700 nm or shorter, is 2% or more and 80% or less, and a portion of the visible light that is incident thereon is reflectable, is provided on the transparent layer. By providing such a reflective layer on the transparent layer, the light reflected at the reflective layer and the light reflected at the substrate can be caused to interfere with each other, and the metal member can be colored in various color tones. From the viewpoint of increasing the chroma of the metal member and coloring in more vivid color tones, the mean value of the spectral transmittance of the reflective layer, in the wavelength range of 400 nm or longer and 700 nm or shorter, is preferably 20% or more and 70% or less, and more preferably 30% or more and 60% or less.

The aforementioned mean value of the spectral transmittance of the reflective layer can be calculated by the following method. First, the spectral transmittance of the reflective layer is measured at multiple wavelengths, within the wavelength range of 400 nm or longer and 700 nm or shorter. At this time, from the viewpoint of more accurately calculating the mean value of the spectral transmittance of the reflective layer, it is preferable to measure the spectral transmittance of the reflective layer at multiple wavelengths, which have been determined so that the wavelength interval is constant. In addition, the wavelength interval at which the spectral transmittance is measured is preferably, for example, 20 nm or less. The value resulting from finding the arithmetic mean for spectral transmittance at the multiple wavelengths obtained as above is taken as the mean value of the spectral transmittance of the reflective layer.

For example, the reflective layer may be composed of a metal or may be composed of a metal compound. In addition, the reflective layer may also contain both a metal and a metal compound. If the reflective layer is composed of a metal and/or a metal compound, the thickness of the reflective layer is preferably 2 nm or more and 30 nm or less. In this case, the mean value of the spectral transmittance of the reflective layer can be more easily adjusted within the specific range.

For example, aluminum, copper, silver, platinum, and the like can be used as the metal that constitutes the reflective layer. In addition, for example, oxides of copper and sulfides of silver can be used as the metal compound that constitutes the reflective layer. Among these, from the viewpoint of more reliably obtaining the aforementioned functions and effects, it is preferable that the reflective layer contains copper atoms or silver atoms.

The reflective layer more preferably contains a metal compound. Because metal compounds are less likely to deteriorate in the atmosphere, the optical properties of the reflective layer can be maintained over longer periods of time. Thus, by providing a reflective layer, which is composed of a metal that contains a metal compound, on the transparent layer, the vivid color tone of the metal member can be maintained over a longer period of time. From the viewpoint of more reliably obtaining such an effect, the reflective layer preferably contains an oxide of copper or a sulfide of silver, and more preferably contains an oxide of copper.

From the viewpoint of more reliably imparting the aforementioned optical properties to the reflective layer, it is preferable that the reflective layer contains a plurality of crystal grains. In addition, it is more preferable that the mean grain size of the crystal grains contained in the reflective layer is 3 nm or more and 15 nm or less.

The mean grain size of the aforementioned crystal grains is calculated as follows. First, a cross-section of the reflective layer is observed using a high-resolution transmission electron microscope to obtain an electron microscope image of the reflective layer. Next, the circle equivalent diameters of crystal grains present in the electron microscope image, which is to say, the diameters of circles equivalent to the cross-sectional areas of the crystal grains, are calculated. The arithmetic mean value of the circle equivalent diameters of the crystal grains obtained in this manner is taken as the mean grain size of the crystal grains.

A protective layer, which is composed of a material that transmits visible light, may be further provided on the reflective layer of the metal member. In this case, deterioration of the reflective layer due to reactions with oxygen, water, sulfur, or the like in the atmosphere can be curtailed over a longer period of time, and the vivid chromatic color of the metal member can be maintained over a longer period of time.

The material that constitutes the protective layer may be an organic material or may be an inorganic material. For example, transparent resins such as acrylic resin, methacrylic resin, polycarbonate resin, nitrocellulose resin, and organic glass and the like can be preferably used as the protective layer.

Method for Manufacturing the Metal Member

The metal member can be obtained, for example, by performing an anodizing treatment on the substrate in a weakly acidic or weakly basic electrolytic solution so as to form a transparent layer, and then performing a sputtering treatment to form a reflective layer on the transparent layer.

The electrolytic solution used for the anodizing treatment may be a weakly acidic electrolytic solution or a weakly basic electrolytic solution. More specifically, examples of weakly acidic electrolytic solutions include electrolytic solutions that use, for example, phosphates, borates, adipic acid, or the like as electrolytes and have a pH of 3.5 or higher and 7 or lower. In addition, examples of weakly basic electrolytic solutions include electrolytic solutions that use, for example, borates, phosphates, or the like as electrolytes and have a pH of 7 or higher and 8 or lower.

In addition, in the anodizing treatment, the treatment method is preferably any of direct current electrolysis performed by applying a voltage of 10 V or higher and 400 V or lower, alternating current electrolysis performed by applying a voltage so that the peak voltage is 10 V or higher and 400 V or lower, or pulsed electrolysis. Because the transparent layer formed in this manner is composed of an oxide of the metal that constitutes the substrate and does not have pores, scattering of light at the transparent layer can be further reduced. Accordingly, by performing the anodizing treatment by the aforementioned treatment method, it is possible to more easily obtain a metal member having a vivid chromatic color.

In addition, in the sputtering treatment, the treatment method is preferably DC magnetron sputtering. In this case, variations in the thickness of the reflective layer formed on the transparent layer can be further reduced, and crystal grains can be more easily formed in the reflective layer. Furthermore, owing to the DC magnetron sputtering, the grain size of the crystal grains in the reflective layer can be more easily controlled. Thus, performing sputtering treatment in the aforementioned treatment method allows a reflective layer having the desired optical properties to be more easily formed on the transparent layer such that a metal member having a vivid chromatic color can be more easily obtained.

Argon can, for example, be used as the atmospheric gas in the chamber during the DC magnetron sputtering. In this case, it is preferable that the degree of vacuum in the chamber is 0.05 Pa or more and 5 Pa or less, and the current density applied to the sputtering target is 0.1 $mA/cm^2$ or higher and 7 $mA/cm^2$ or lower. By performing DC magnetron sputtering under such conditions, it is possible to more easily form a reflective layer having the desired optical properties on the transparent layer.

Exemplary Embodiments

Exemplary Embodiment 1

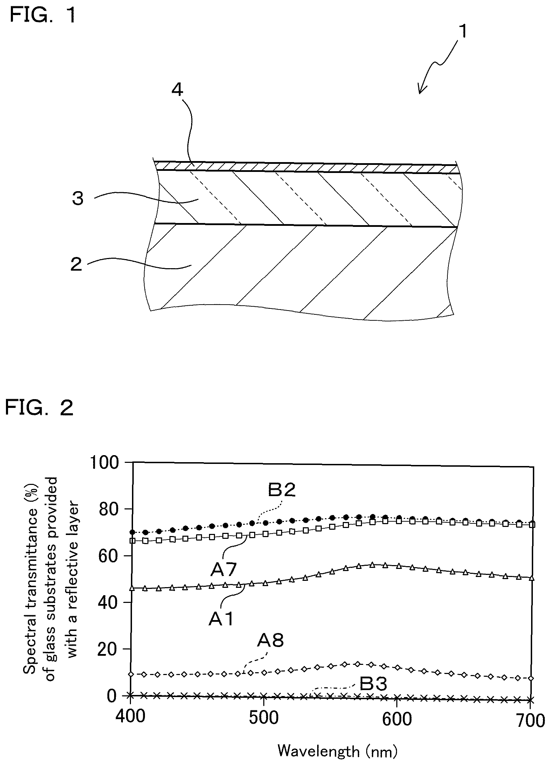

Exemplary embodiments of the metal member will be described with reference to FIG. 1 to FIG. 3. As shown in FIG. 1, the metal member 1 in this example has a substrate 2, which is composed of a metal, a transparent layer 3, which is composed of a material that transmits visible light, and which is provided on the substrate 2, and a reflective layer 4, which is provided on the transparent layer 3. The mean value of the spectral transmittance of the reflective layer 4, in the wavelength range of 400 nm or longer and 700 nm or shorter, is 2% or more and 80% or less. In addition, the reflective layer 4 is constituted such that a portion of the visible light that is incident on the reflective layer 4 can be reflected. The metal member 1 in this example is obtained by performing an anodizing treatment on the substrate 2 so as to form a transparent layer 3, and then performing a sputtering treatment so as to form a reflective layer 4 on the transparent layer 3. Hereafter, the constitution of the metal member 1 and the method for manufacturing the same will be described in more detail.

The substrate 2 in the metal member 1 of this example is a sheet material composed of aluminum having a chemical composition that is represented by the alloy number A1050. In preparing the metal member 1, the surface of the substrate 2 is first smoothed by performing electropolishing of the substrate 2. Subsequently, an anodizing treatment is performed on the substrate 2 to form a barrier-type anodic oxide film as the transparent layer 3 on the surface of the substrate 2. Direct current electrolysis is employed as the treatment method in the anodizing treatment, and the applied voltage is increased to the voltage shown in Table 1 over 2.5 minutes from the start of the treatment. In addition, a weakly basic electrolytic solution containing 0.5 mol/L of boric acid and 0.05 mol/L of sodium tetraborate is used as the electrolytic solution in the anodizing treatment. In addition, the temperature of the electrolytic solution in the anodizing treatment is 20°C.

The thickness of the transparent layer 3 formed by the direct current electrolysis varies depending on the applied voltage in the anodizing treatment. For example, when performing direct current electrolysis at the voltages shown in Table 1, the values for the thickness of the transparent layer 3 formed on the substrate 2 are shown in Table 1.

Subsequently, a reflective layer 4, which is composed of one of the metals, from among copper, silver, or aluminum, as shown in Table 1, is formed on the transparent layer 3 by performing a sputtering treatment. DC magnetron sputtering is employed as the treatment method in the sputtering treatment. In addition, argon is used as the atmospheric gas in the chamber in the DC magnetron sputtering, the degree of vacuum in the chamber is 0.05 Pa or more and 5 Pa or less, and the current density applied to the sputtering target is 0.1 $mA/cm^2$ or higher and 7 $mA/cm^2$ or lower. Note that the thickness of the reflective layer 4 shown in Table 1 is a value measured by a quartz crystal microbalance method. It is thereby possible to obtain metal members 1 (Test Materials A1 to A11) having the constitutions shown in Table 1.

Note that Test Materials B1 to B3 shown in Table 1 are test materials for comparison with Test Materials A1 to A11. Test Material B1 has the same constitution as Test Materials A1 to A6 except that it does not have the transparent layer 3. The manufacturing method for Test Material B1 is the same as the manufacturing method for Test Materials A1 to A6 except that anodizing treatment is not performed. In addition, Test Material B2 and Test Material B3 have the same constitution as Test Material A2, Test Material A7, and Test Material A8, except that the mean values of the spectral transmittance at the reflective layer 4 are different. The manufacturing method for Test Materials B2 and B3 is the same as the manufacturing method for Test Material A2, Test Material A7, and Test Material A8, except that the thickness of the reflective layer 4 in the sputtering treatment is changed.

Evaluation methods of the various properties shown in Table 1 are, specifically, as follows.

Mean Value of the Spectral Transmittance of the Reflective Layer

Reflective layers 4 are formed on glass substrates by a treatment method that is the same as the sputtering treatment for each of the test materials, and the spectral transmittance of the reflective layers 4 at various wavelengths is measured at 10 nm intervals within the wavelength range of 400 nm or longer and 700 nm or shorter. Note that the light source used in the measurement of spectral transmittance is Auxiliary Illuminant C, stipulated in JIS Z8720:2012. In addition, the geometric conditions at the time of measurement are Geometric Conditions f indicated by the symbol 0°:di in JIS Z8722:2009 (that is to say, conditions in which the light is irradiated from a direction such that the angle with respect to the normal to the surface of the transmissive layer is 0°, and in which all of the transmitted light, including the regular transmitted light, is collected), and the light is irradiated in a measurement region with a diameter of 30 mm.

FIG. 2 shows, as examples, the spectral transmittance at various wavelengths for glass substrates provided with a layer similar to the reflective layer in Test Material A1, Test Material A7, Test Material A8, Test Material B2, and Test Material B3. The vertical axis in FIG. 2 is the spectral transmittance (unit: %) and the horizontal axis is the measurement wavelength (unit: nm).

The spectral transmittance at each wavelength obtained by the above method includes not only contributions such as light absorption at the reflective layer 4 but also contributions such as light absorption at the glass substrate. The spectral transmittance of the reflective layer 4 alone $T_r$ (unit: %) can be calculated based on the following equation (1), using the spectral transmittance at each wavelength obtained by measuring the reflective layer 4 on the glass substrate $T_m$ (unit: %) and the spectral transmittance at each wavelength of the glass substrate $T_{glass}$ (unit: %).

$$T_r = T_m \times (100/T_{glass}) \qquad \ldots(1)$$

After performing a correction that excludes the influence of the glass substrate from the spectral transmittance $T_m$ measured at each wavelength in aforementioned manner, the mean value of the spectral transmittance of the reflective layer 4 can be obtained by finding the arithmetic mean of the corrected spectral transmittance $T_r$. The mean value of the spectral transmittance obtained in this manner is shown in the "Mean Value of Spectral Transmittance" column in Table 1.

Color tone of the metal member 1

Evaluations of the color tone of the metal members 1 were performed by visual observation and with a spectrophotometer. The color tones of the metal members 1 determined by visual observation are entered in the "Color Tone (visual)" column in Table 1. In addition, the color coordinates in CIE 1976 (L*, a*, b*) color space measured using a spectrophotometer are entered under "Color Coordinates" in Table 1. The light source used in the measurement of the color coordinates is Auxiliary Illuminant C stipulated in JIS Z8720:2012. In addition, the geometric conditions at the time of measurement are the conditions indicated by the symbol 8°:de in JIS Z8722:2009 (that is to say, conditions in which the light is irradiated from a direction such that the angle with respect to the normal to the reflective layer is 8°, and in which the reflected light, excluding regularly reflected light, is collected), and the light is irradiated in a measurement region having a diameter of 15 mm. Furthermore, the chroma calculated based on the color coordinates is entered in the "Chroma" column in Table 1. Note that, specifically, chroma is the square root of the sum of the square of the a* value and the square of the b* value, meaning that the higher the chroma is, the more vivid the color tone of the metal member 1 will be.

[Table 1]

(Table 1)

| Test Material Symbol | Transparent Layer | | Reflective Layer | | | Color Tone (visual) | Color Coordinates | | | |
|---|---|---|---|---|---|---|---|---|---|---|
| | Applied Voltage (V) | Thickness (nm) | Material | Thickness (nm) | Mean Value of Spectral Transmittance (%) | | L* | a* | b* | Chroma |
| A1 | 10 | 15 | Cu | 5 | 56.6 | light green | 41.9 | 1.2 | 12.1 | 12.2 |
| A2 | 50 | 75 | Cu | 5 | 56.6 | dark blue | 14.6 | 15.8 | -17.9 | 23.9 |
| A3 | 150 | 225 | Cu | 5 | 56.6 | orange | 35.3 | 21.1 | 22.1 | 30.5 |
| A4 | 250 | 375 | Cu | 5 | 56.6 | yellow | 47.4 | -0.5 | 37.0 | 37.0 |
| A5 | 350 | 525 | Cu | 5 | 56.6 | green | 41.4 | -38.6 | 23.7 | 45.2 |
| A6 | 400 | 600 | Cu | 5 | 56.6 | purple | 43.1 | 24.9 | -6.9 | 25.8 |
| A7 | 50 | 75 | Cu | 2 | 78.6 | dark blue | 25.0 | 9.1 | -7.3 | 11.7 |
| A8 | 50 | 75 | Cu | 20 | 12.1 | light purple | 33.7 | 7.3 | 0.3 | 7.3 |
| A9 | 50 | 75 | Ag | 5 | 65.9 | light green | 14.6 | -0.9 | 13.2 | 13.2 |
| A10 | 200 | 300 | Ag | 5 | 65.9 | light pink | 43.4 | 9.5 | -12.4 | 15.6 |
| A11 | 50 | 75 | Al | 10 | 9.2 | light green | 49.1 | -1.0 | 3.3 | 3.4 |
| B1 | - | 0 | Cu | 5 | 56.6 | grey | 49.2 | 0.1 | 7.1 | 7.1 |
| B2 | 50 | 75 | Cu | 1 | 81.8 | grey | 35.1 | 1.3 | -8.9 | 9.0 |
| B3 | 50 | 75 | Cu | 50 | 0.4 | grey | 39.4 | 4.5 | 5.2 | 6.9 |

As shown in Table 1, Test Materials A1 to A11 include a reflective layer 4 having a mean value of spectral transmittance at wavelengths of 400 nm or longer and 700 nm or shorter within the specific range. Therefore, these test materials develop vivid chromatic colors.

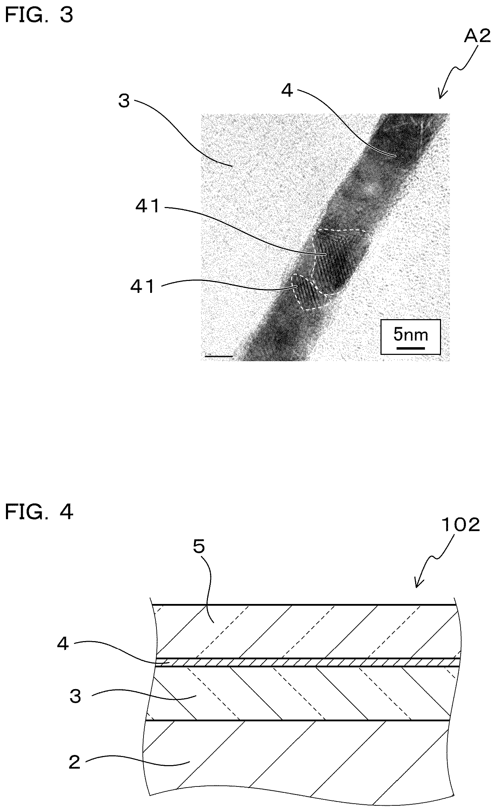

As an example of the structure of the reflective layer 4 in these test materials, FIG. 3 shows a transmission electron microscope image obtained by observing the cross-section of the reflective layer 4 of Test Material A2 using a transmission electron microscope. As shown in FIG. 3, it can be understood that crystal grains 41, which exhibit a pattern of stripes arranged at equal intervals, are present in the cross-section of the reflective layer 4. In addition, although not shown in the figure, by performing observations with the angle of the sample stage variously changed, the striped pattern also appears in portions where a striped pattern does not appear in FIG. 3. Thus, according to these results, it can be understood that the reflective layer 4 of Test Material A2 is a polycrystal composed of a plurality of crystal grains 41. The mean value of the circle equivalent diameters of the crystal grains 41 in the reflective layer 4 of Test Material A2 is approximately 7 nm.

However, because Test Material B1 is not provided with a transparent layer 3 between the substrate 2 and the reflective layer 4, the phase difference between the light reflected at the surface of the reflective layer 4 and the light reflected at the surface of the substrate 2 is insufficient. Therefore, the color tone of Test Material B1 is an achromatic color, and a vivid chromatic color cannot be expressed.

In Test Material B2 and Test Material B3, since the mean value of the spectral transmittance of the reflective layer 4 is outside the specific range, either one of the light reflected at the surface of the reflective layer 4 and the light reflected at the surface of the substrate 2 is excessively weak compared to the other light. Therefore, the color tones of these test materials are achromatic colors, and vivid chromatic colors cannot be manifested.

Exemplary Embodiment 2

In this example, an example of a metal member 102 provided with a protective layer 5 on the reflective layer 4 will be shown. Note that, among the reference numerals used in this example, unless otherwise described, the same reference numerals as the reference numerals used in the previous examples indicate the same components or the like as in the previous examples.

As shown in FIG. 4, the metal member 102 in this example has a substrate 2, a transparent layer 3 formed on the substrate 2, a reflective layer 4 formed on the transparent layer 3, and a protective layer 5, which is composed of a material that transmits visible light, and which is formed on the reflective layer 4. The constitutions of the substrate 2, the transparent layer 3, and the reflective layer 4 are similar to the constitutions of the corresponding portions in Exemplary Embodiment 1.

The protective layer 5 in this example is specifically composed of nitrocellulose resin.

Metal members 102 of this example can be obtained by forming a transparent layer 3 and a reflective layer 4 on a substrate 2 by the same method as in Exemplary Embodiment 1, and then forming a film composed of a nitrocellulose resin on the reflective layer 4. In Table 2, the manufacturing conditions, constitutions, and various properties of the metal members 102 (Test Materials C1 and C2) in this example are indicated.

[Table 2]

(Table 2)

| Test Material Symbol | Transparent Layer | | Reflective Layer | | | Color Tone (visual) | Color Coordinates | | | |
|---|---|---|---|---|---|---|---|---|---|---|
| | Applied Voltage (V) | Thickness (nm) | Material | Thickness (nm) | Mean Value of Spectral Transmittance (%) | | L* | a* | b* | Chroma |
| C1 | 50 | 75 | Cu | 5 | 56.6 | light purple | 54.3 | -7.8 | 5.7 | 9.7 |
| C2 | 350 | 525 | Cu | 5 | 56.6 | green | 55.0 | -38.5 | 35.5 | 52.4 |

As shown in Table 2, the metal members 102 have a vivid chromatic color, even when the protective layer 5 is provided on the reflective layer 4. In addition, by providing the protective layer 5 on the reflective layer 4, in the manner of the metal member 1 in this example, deterioration of the reflective layer 4 can be curtailed over a longer period of time, and thus the color tone of the metal member 1 can be maintained over a longer period of time. Note that, comparing Test Material C1 shown in Table 2 and Test Material A2 shown in Table 1, the two have different color tones even though the constitutions of the transparent layer 3 and the reflective layer 4 are the same. Similarly, comparing Test Material C2 shown in Table 2 and Test Material A5 shown in Table 1, the two have different color tones even though the constitutions of the transparent layer 3 and the reflective layer 4 are the same. This is thought to be because, in Test Material C1 and Test Material C2, a protective layer 5 is formed on the reflective layer 4, and the optical path of the light changes as it passes through the protective layer 5, thereby changing the wavelength at which the amplitude is intensified by interference.

Although specific aspects of the metal member and the method for manufacturing the same according to the present invention have been described based on Exemplary Embodiments 1 and 2 above, the aspects of the metal member and the method for manufacturing the same according to the present invention are not limited by the aspects in the exemplary embodiments, and the constitutions thereof can be modified as appropriate within a scope that does not depart from the gist of the present invention.

**Claims**

1.   A metal member having:

a substrate, which is composed of a metal;
a transparent layer, which is composed of a material that transmits visible light, and is provided on the substrate; and
a reflective layer, which is provided on the transparent layer,
wherein the reflective layer is constituted such that the mean value of the spectral transmittance, in a wavelength range of 400 nm or longer and 700 nm or shorter is, 2% or more and 80% or less and a portion of the visible light that is incident on the reflective layer is reflectable.

2.  The metal member according to claim 1, wherein the transparent layer is composed of an oxide of a metal that constitutes the substrate.

3.  The metal member according to claim 1 or 2, wherein the thickness of the transparent layer is 15 nm or more and 600 nm or less.

4.  The metal member according to any one of claims 1 to 3, wherein the reflective layer is composed of a metal and/or a metal compound and has a thickness of 2 nm or more and 30 nm or less.

5.  The metal member according to any one of claims 1 to 4, wherein the reflective layer contains copper atoms or silver atoms.

6.  The metal member according to claim 5, wherein the reflective layer contains a plurality of crystal grains, and the mean grain size of the crystal grains is 3 nm or more and 15 nm or less.

7.  The metal member according to any one of claims 1 to 6, wherein the substrate is composed of aluminum or an aluminum alloy.

8.  The metal member according to any one of claims 1 to 7, wherein the metal member further has a protective layer, which is composed of a material that transmits visible light, and is provided on the reflective layer.

9.  A method for manufacturing a metal member according to any one of claims 1 to 8, wherein:

    the transparent layer is formed by performing an anodizing treatment on the substrate in a weakly acidic or weakly basic electrolytic solution; and
    thereafter the reflective layer is formed on the transparent layer by performing a sputtering treatment.

10. The method for manufacturing a metal member according to claim 9, wherein the treatment method in the anodizing treatment is any of direct current electrolysis performed by applying a voltage of 10 V or higher and 400 V or lower, alternating current electrolysis performed by applying a voltage so that the peak voltage is 10 V or higher and 400 V or lower, or pulsed electrolysis.

11. The method for manufacturing a metal member according to claim 9 or 10, wherein the treatment method in the sputtering treatment is DC magnetron sputtering.

FIG. 1

FIG. 2

FIG. 3

FIG. 4

## INTERNATIONAL SEARCH REPORT

International application No.

**PCT/JP2024/003541**

| A. | CLASSIFICATION OF SUBJECT MATTER |
|---|---|

*C25D 11/18*(2006.01)i; *B32B 7/023*(2019.01)i; *B32B 9/00*(2006.01)i; *B32B 9/04*(2006.01)i; *B32B 15/04*(2006.01)i; *B32B 15/20*(2006.01)i; *C23C 26/00*(2006.01)i; *C23C 28/02*(2006.01)i; *C25D 11/04*(2006.01)i; *G02B 5/08*(2006.01)i
FI: C25D11/18 311; B32B7/023; B32B9/00 A; B32B9/04; B32B15/04 Z; B32B15/20; C23C26/00 D; C23C26/00 F; C23C28/02; C25D11/04 101A; G02B5/08 Z

According to International Patent Classification (IPC) or to both national classification and IPC

| B. | FIELDS SEARCHED |
|---|---|

Minimum documentation searched (classification system followed by classification symbols)

C25D11/18; B32B7/023; B32B9/00; B32B9/04; B32B15/04; B32B15/20; C23C26/00; C23C28/02; C25D11/04; G02B5/08

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| X | US 2020/0024185 A1 (KCC CORPORATION) 23 January 2020 (2020-01-23) paragraphs [0031]-[0054], table 7 | 1, 3-4 |
| A | entire text | 2, 5-11 |
| A | JP 2013-118405 A (MITSUBISHI ELECTRIC CORPORATION) 13 June 2013 (2013-06-13) entire text | 1-11 |

☐ Further documents are listed in the continuation of Box C.    ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **13 March 2024** | **26 March 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (July 2022)

**INTERNATIONAL SEARCH REPORT**
**Information on patent family members**

International application No.

**PCT/JP2024/003541**

| Patent document cited in search report | Publication date (day/month/year) | Patent family member(s) | Publication date (day/month/year) |
|---|---|---|---|
| US 2020/0024185 A1 | 23 January 2020 | WO 2018/194348 A1 paragraphs [0056]-[0063], table 7 KR 10-2018-0116566 A CN 110494588 A | |
| JP 2013-118405 A | 13 June 2013 | (Family: none) | |

**EP 4 624 637 A1**

**Patent documents cited in the description**

- JP 2014004700 A